# EUROPEAN PATENT APPLICATION

(11) **EP 3 255 787 A1**
(43) Date of publication of application: **13.12.2017**
(21) Application number: 16746167.2
(22) Date of filing: 04.02.2016
(51) Int. Cl.: H02S 40/44, F24J 2/34

(54) **INTEGRAL SOLAR COLLECTION COVER**

(30) Priority: 04.02.2015 ES 201530142
(71) Applicant: Mirasol Gieb, Enrique, 18193 Monachil (Granada) (ES)
(72) Inventor: Mirasol Gieb, Enrique, 18193 Monachil (Granada) (ES)
(74) Representative: Munoz Garcia, Antonio
(86) International application number: PCT/ES2016/070063
(87) International publication number: WO 2016/124806

(57) **Abstract**

The invention relates to an integral solar collection cover designed for a carrier structure (2) which is anchored to the slab (3), a waterproofing layer for waterproofing channelled plates (4) and solar covering plates (5), and optionally, conventional plates (6), all of the solar covering plates (5) being hybrid, integrating the installation and photovoltaic solar collection devices for generating electrical energy, and thermal solar collection devices for generating domestic hot water and heat. Said solar plates (5) are "sandwich"-type panels made of polyester, transparent resins and polyurethane, comprising an upper layer (5a) which is flat or undulating with different finishes, below which there are installed photovoltaic cells (12) with wiring (13), electrical connectors and components, and a thermal water pipe circuit (14), which is inserted in cavities (15) that have been filled with a non-evaporable, low-boiling liquid, and provided with inflow connections (14a) and outflow connections (14b).

## Description

### Object of the Invention

As expressed in the title of the present specification, the invention relates to an integral solar collection cover, which provides for the function for which it is intended several advantages and novel features that entail a significant improvement in the current state of the art in its field of application and will be explained more in detail below.

More particularly, the object of the invention relates to a cover formed by the set of elements arranged on the final slab of an edification for thermally and acoustically isolating it, as well as isolating it from bad weather, which furthermore constitutes the solar energy collection system, as a result of the incorporation of solar panels incorporated therein, having the particularity that said panels, which can externally imitate natural finishes, internally integrate both photovoltaic solar collection devices for obtaining electrical energy and thermal solar collection devices for domestic hot water and heat.

### Field of Application of the Invention

The field of application of the present invention is comprised in the technical sector of the construction industry and in the industry dedicated to the manufacture and installation of solar energy collection systems.

### Background of the Invention

In reference to the state of the art, it should be pointed out that the current applicant is the proprietor of patent application number P200900824, which already discloses a "Thermal Solar Collection Cover", the essential objective of which is the development of a cover in which the solar energy system, i.e., the solar plates and the accompanying installation channelling elements, are integrated in the actual roof of the building, being part of same.

However, although said cover meets the objectives that are sought, it has certain aspects susceptible to improvement, particularly those relating to the type of solar panels installed as solar covering plates, since these are either all photovoltaic-type plates, or thermal-type plates, or panels of both types, the objective of the present invention being the development of a new cover with an improved system of the solar energy collection system integrated therein, such that all the panels are hybrid-type panels, i.e., with both solar collection systems integrated together.

### Description of the Invention

Therefore, the new integral solar collection cover proposed by the invention is designed as a novelty in its field of application, the characterizing details being suitably described in the claims attached at the end of the present description.

Specifically, the invention proposes a cover essentially formed from the following elements:
- a lightweight metallic structure, designed according to the needs of each case, which constitutes the assembly carrier member;
- a channelling layer which is formed by thin plates, intended for collecting possible water infiltrations of the upper layer caused by leakages or breakages that the solar panels may have, for example, and is anchored to the structure acting as a second cover;
- a plurality of solar collection covering plates which serve at the same time as a roof of the building and as a solar plate; and
- a plurality of conventional covering plates which are externally identical to the solar collection plates but lacking any installation whatsoever, serving to fill in the spaces not covered by the solar plates and ensuring aesthetic continuity of the cover.

From this configuration which is already known through said earlier patent, the cover is different in that the solar collection covering plates are plates integrating the installation and devices pertaining to both photovoltaic solar technology for generating electrical energy and thermal solar technology for generating domestic hot water and heat, where it can constitute the covering of the building or be a passable cover, without losing its solar collection features.

To that end, said solar collection covering plates are made up of "sandwich"-type panels made of polyester and polyurethane which can externally have a surface imitating different conventional covering elements of a building, for example imitating a slate cover, but made of polyester, and internally integrating photovoltaic cells and the relevant connections for supplying electrical energy, and a fluid thermal circuit for supplying hot water.

All the solar collection covering plates of the cover are thus designed as a natural covering element serving at the same times as a solar collection element for photovoltaic energy and domestic hot water.

It should be pointed out that the solar covering plates could be undulating or flat on the outer face thereof, but they are always smooth on the rear face thereof. Internally, in addition to the photovoltaic cells, non-evaporable low-boiling liquids are also incorporated in the cavities provided in the core of the mentioned sandwich formed by the plates, which liquids transfer heat to the water pipe circuit when heated, serving as domestic hot water and/or for being used as heat. They are connected in a closed circuit and with a water tank, which is duly isolated and calculated for adapting external thermal conditions to maximum supply needs in terms of temperature and time for heating the desired surfaces. Furthermore, in very cold areas said plates could have antifreeze liquids.

It should finally be pointed out that the metallic carrier structure is essentially formed by trusses, purlins, brackets and other conventional elements, according to the tilting or flat configuration the cover has in each case, whereas the waterproofing plates are formed by gutters made of galvanized sheet metal arranged under the covering plates such that they collect any water that may be filtered through said covering element *per se,* which is a photovoltaic and thermal solar plate at the same time. Furthermore, they are preferably arranged on the slab itself with a layer of insulating material.

The cover furthermore allows changing plate modulation and format since said plates are formed with materials such as resins.

The integral solar collection cover described herein therefore represents an innovation in structural and constitutive features unknown up until now which, combined with its practical usefulness, provides sufficient grounds for granting the exclusive right that is requested.

### Description of the Drawings

To complement the description that is being made and to help better understand the features of the invention, a set of drawings is attached to the present specification as an integral part thereof in which the following has been depicted with an illustrative and non-limiting character:
Figure 1 shows a highly schematic perspective view of an embodiment of the integral solar collection cover, object of the invention, depicted in the assembly phase, where the main parts and elements comprised therein can be seen.
Figure 2 shows an also highly schematic section view of one of the solar covering plates contemplated in the cover according to the invention, where the sandwich-type configuration and the elements incorporated therein can be seen.

### Preferred Embodiment of the Invention

In view of the mentioned drawings and according to the reference numbers used, a non-limiting example of the proposed cover can be seen therein, said cover comprising the parts and elements indicated and described in detail below.

As seen in said drawings, the cover (1) in question is designed based on a lightweight metallic carrier structure (2) designed according to the needs of each case, which is anchored onto the final slab (3) of the building, and on which there is installed a channelling layer formed by waterproof channelled plates (4), and installed thereon and likewise anchored to said carrier structure (2) there are solar covering plates (5) and conventional covering plates (6), i.e., there being no solar energy collection installation, which are externally identical to the solar covering plates (5), but serving only for filling in spaces not covered by the former and achieving an aesthetic continuity of the cover (1), although the solar covering plates (5) could optionally be modulated such that the entire surface is a solar collection surface.

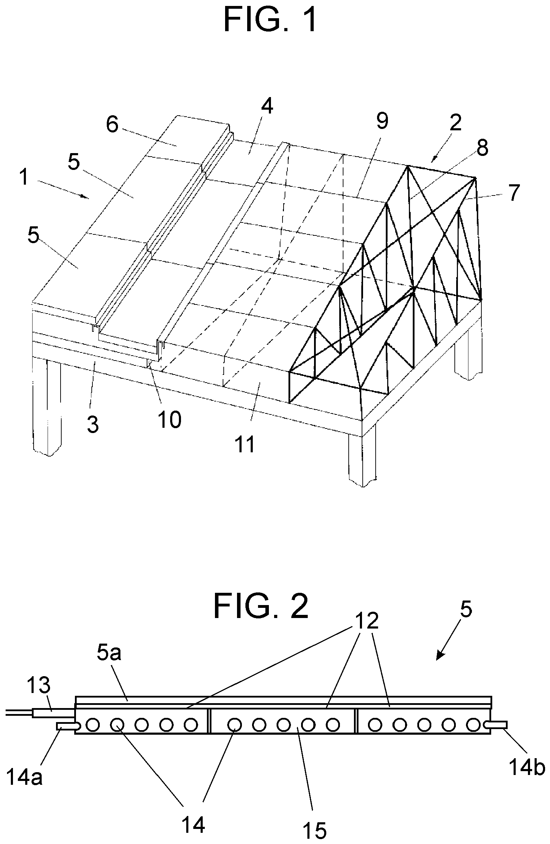

It should be pointed out that the carrier structure (2) can be, for example, tilted, being formed by triangular trusses (7), cross pieces (8) connecting them to one another, and transverse purlins (9), as shown in the embodiment depicted in Figure 1, and it can also be flat, formed in that case with different elements.

In any case, the channelled plates (4) forming the waterproofing layer are fixed on the upper elements of the carrier structure (2), in this case the transverse purlins (9), for collecting any possible rain water that may have filtered between the solar covering plates (5) arranged thereon and likewise anchored to the carrier structure (2), or the water from a possible leakage or breakage of said plates, the existence of a gutter (10) being contemplated at the lower edge for collecting said water and taking it to the corresponding downspouts.

Preferably, the cover also contemplates installing an insulating layer (11) on the actual slab (3), said insulating layer (11) being made of the most suitable material in each case, according to different needs.

In any case, what stands out most about the cover (1) is the fact that all the solar covering plates (5) are hybrid plates, i.e., they integrate the installation and photovoltaic solar collection devices for generating electrical energy, and thermal solar collection devices for generating domestic hot water or hot water and heat.

Specifically, as seen in the schematic depiction in Figure 2, solar covering plates (5) are made up of "sandwich"-type panels made of polyester, transparent resins and polyurethane, essentially comprising an upper layer (5a), the visible face of which can be flat or undulating and have different finishes, for example imitating conventional covering materials such as slate, below which there are installed photovoltaic cells (12) with wiring (13), electrical connectors and components required for providing electrical energy, and a thermal water pipe circuit (14), which is inserted in cavities (15) of the core of said sandwich that have been filled with a non-evaporable, low-boiling liquid, said circuit also having inflow connections (14a) and outflow connections (14b) for the coupling thereof to the building water circuit for supplying domestic hot water, and optionally heat as well.

Furthermore, the cover (1) contemplates being able to change elements that collect the heat and maintaining it to make it easier to heat water, even when the sun is not out.

Having sufficiently described the nature of the present invention as well as how to put it into practice, no further explanation is needed for a person skilled in the art to understand its scope and the advantages derived from it.

Likewise, within its essential features, the invention may be carried out to practice in other embodiments differing in detail from the embodiment indicated by way of example, and such embodiments would also be covered by the protection granted provided that the fundamental principle thereof is not altered, changed or modified.

## Claims

1. An integral solar collection cover, designed based on a carrier structure (2) which is anchored onto the final slab (3) of the building, on which there is installed a waterproofing layer formed by channelled plates (4), and installed thereon and likewise anchored to said carrier structure (2) there are solar covering plates (5), and optionally, conventional covering plates (6), i.e., there being no solar energy collection installation, which are externally identical to the solar covering plates (5), but serving only for filling in spaces not covered by the former and achieving an aesthetic continuity of the cover (1), **characterized in that** all the solar covering plates (5) are hybrid plates integrating the installation and photovoltaic solar collection devices for generating electrical energy, and thermal solar collection devices for generating domestic hot water or for hot water and heating purposes.

2. The integral solar collection cover according to claim 1, **characterized in that** the solar covering plates (5) are made up of "sandwich"-type panels comprising at least one upper layer (5a) below which there are installed photovoltaic cells (12) with wiring (13), electrical connectors and components for providing electrical energy, and a thermal water pipe circuit (14), which is inserted in cavities (15) of the core of said sandwich that have been filled with a non-evaporable, low-boiling liquid, this circuit being provided with inflow connections (14a) and outflow connections (14b) for the coupling thereof to the building water circuit.

3. The integral solar collection cover according to claim 2, **characterized in that** the solar covering plates (5) are made up of panels made of polyester, transparent resins and polyurethane, comprising at least one upper layer (5a) the face of which is flat or undulating and has different finishes, for example imitating conventional covering materials such as slate.
